# EUROPÄISCHE PATENTSCHRIFT

(11) **EP 0 652 692 B1**
(45) Veröffentlichungstag und Bekanntmachung des Hinweises auf die Patenterteilung: **25.03.1998**
(21) Anmeldenummer: 94203162.6
(22) Anmeldetag: 31.10.1994
(51) Int. Cl.: H05K 1/03, H05K 1/14

(54) **Verfahren zur Montage eines Bauteils auf einer Basisleiterplatte**
Process for mounting a component on a printed circuit base board
Procédé de montage d'un composant sur une plaque de base à circuit imprimé

(30) Priorität: 06.11.1993 DE 4337960
(43) Veröffentlichungstag der Anmeldung: 10.05.1995
(73) Patentinhaber: LUCENT TECHNOLOGIES INC., Murray Hill, New Jersey 07974-0636 (US)
(72) Erfinder: Ziegler, Bernhard, D-20097 Hamburg (DE)
(74) Vertreter: Tergau, Enno, Dipl.-Ing.

(56) Entgegenhaltungen:
- DE-A- 2 514 176
- DE-A- 3 703 364
- FR-A- 1 384 727
- FR-A- 2 407 815
- GB-A- 2 137 425
- US-A- 4 997 702
- IBM TECHNICAL DISCLOSURE BULLETIN., Bd.14, Nr.11, April 1972, NEW YORK US Seite 3304 I. MEMIS ET AL. 'Bent thermoset printed-circuit boards'

## Beschreibung

Die Erfindung bezieht sich auf ein Verfahren zur Montage eines Bauteils auf einer Basisleiterplatte gemäß dem Oberbegriff des Anspruchs 1.

Es ist häufig erforderlich, bestimmte Bauelemente sowohl mit ihren an der Unterseite als auch mit ihren an der Oberseite angeordneten Anschlußstiften mit Leiterbahnen auf einer Basisleiterplatte elektrisch zu verbinden. Dazu werden diese Bauelemente mit ihren an der Unterseite angeordneten Anschlußstiften in entsprechende Bohrungen auf der Basisleiterplatte gesteckt und dann verlötet. Es ist bekannt, die obenliegenden Anschlußstifte über eine flexible Leiterplatte aus Polyimid (Dauerflexeigenschaften) oder aus einem Verbundwerkstoff, bestehend aus Epoxidharz und losen Glasfasern, mit der Basisleiterplatte zu verbinden.

Durch die GB-A-21 37 425 und die US-PS 49 97 702 sind Werkstoffe zur Herstellung von gedruckten Schaltungen bekannt geworden, die aus einem Polymerwerkstoff bzw. einem Epoxidharz bestehen mit nicht-gewebten Substraten.

Der Erfindung liegt die Aufgabe zugrunde, ein Verfahren anzugeben, das es ermöglicht, derartige Bauelemente, die sowohl an der Unter- als auch an der Oberseite mit Anschlußstiften versehen sind, z.B. Laser, auf einfache, schnelle und problemlose Weise auf der Basisleiterplatte zu befestigen, wobei eine einwandfreie Kontaktierung der oberen und der unteren Anschlußstifte gewährleistet sein soll.

Diese Aufgabe wird gemäß der Erfindung bei einem Verfahren der eingangs genannten Art gelöst durch die kennzeichnenden Merkmale des Anspruchs 1. Dabei umfaßt eine Anordnung zur Montage eines an seiner Ober- und Unterseite mit Anschlußstiften versehenen Bauteiles, z.B. eines Lasers, auf einer Basisleiterplatte eine mit dieser verbindbare, vorgebogene flexible Leiterplatte zur elektrischen Verbindung der oberen Anschlußstifte mit der Basisleiterplatte, wobei das Bauteil über seine unteren Anschlußstifte direkt mit der Basisleiterplatte verbindbar ist. Dazu besteht die Leiterplatte aus einem Verbundwerkstoff aus einem Epoxidharz und einem Glasfasergewebe besteht, wobei die flexible Leiterplatte beidseitig mit Kupfer beschichtet ist.

Aus derartigem Verbundwerkstoff hergestellte Leiterplatten können in die für die Verwendung geforderte Form vorgebogen werden, so daß sich eine Montageerleichterung ergibt. Ferner sind zur Herstellung solcher Leiterplatten keine speziellen Fertigungstechniken erforderlich, so daß der Aufwand zur Herstellung vermindert wird. Derartige Leiterplatten sind vorzugsweise anwendbar für solche Fälle, in denen die Leiterplatten nur einmal, z.B. zur Montage, gebogen werden. Diese Leiterplatten können somit als Ersatz dienen für jegliche Art von flexiblen Schaltungen oder für starr-flexible Schaltungen, bei denen die Leiterplatte jeweils nur einmal gebogen werden muß. Solche Leiterplatten können somit als reines Verdrahtungselement oder als Baugruppenträger verwendet werden. Ein Verfahren zum Herstellen einer gekrümmten starren Schaltungsplatte sowie eine derartige Schaltungsplatte aus einem Epoxidharz und einem Glasfasergewebe sind aus der DE-A-25 14 176 bekannt.

In Ausgestaltung der Erfindung ist eine eingesetzte Leiterplatte beidseitig mit einer Kupferschicht belegt. Diese Kupferschicht dient dazu, um eine ausreichende Stabilisierung im gebogenen Zustand zu erreichen. Dabei hat sich eine Dicke der Verbundschicht von 0,2 mm und eine Dicke der beidseitig aufgetragenen Kupferschicht von etwa 70 µm als vorteilhaft herausgestellt.

In Ausgestaltung der Erfindung ist vorgesehen, daß der Verbundwerkstoff eine Dicke von 0,2 mm und die beidseitigen Kupferschichten eine Dicke von ca. 70 µm besitzen. Dabei ist die Außenseite vollflächig und die Innenseite in Form von Leiterbahnen zum Teil beschichtet, wobei die Leiterbahnen quer zur Biegeachse verlaufen. Damit ist eine ausreichende Stabilität der gebogenen Leiterplatte gewährleistet. Die Anordnung ist so getroffen, daß durch den Biegevorgang die Glas-Harz-Verbundschicht nicht beschädigt wird.

Vorzugsweise ist vorgesehen, daß die Biegezone mindestens zu 75% mit Kupfer bedeckt ist. Damit soll eine evtl. Beschädigung im Biegebereich vermieden werden.

In der Zeichnung ist in Fig. 1 bis 3 ein Ausführungsbeispiel des Gegenstandes, welcher gemäß der Erfindung erhalten wird, schematisch dargestellt.
Fig. 1 zeigt eine schematische Seitenansicht einer Laser-Befestigung auf einer Basisleiterplatte,
Fig. 2 zeigt eine Frontansicht einer zu biegenden flexiblen Leiterplatte, und
Fig. 3 zeigt eine konstruktive Ausführung der flexiblen Leiterplatte in nicht gebogenem Zustand.

Ein Laser 10 mit untenliegenden Anschlußstiften 11 und obenliegenden Anschlußstiften 12 ist über seine unteren Anschlußstifte 11 direkt mit einer Basisleiterplatte 13 verbunden. Die Verbindung der oberen Anschlußstifte 12 mit der Basisleiterplatte 13 erfolgt erfindungsgemäß über eine vorgebogene Leiterplatte 14, die einerseits mit den Anschlußstiften 12 und andererseits mit nicht dargestellten Leiterbahnen auf der Basisleiterplatte 13 verbunden ist. Die Verbindung mit den Anschlußstiften 12 erfolgt über Bohrungen 15 in der Leiterplatte 14, und die Verbindung mit der Basisleiterplatte 13 erfolgt über Pins 16, die z.B. durch Fräsen aus der Leiterplatte 14 hergestellt sind und über Cu-Leiterbahnen 17 zu den Bohrungen 15 geführt sind. Die Leiterbahnen 17 liegen an der Innenseite der gebogenen Leiterplatte 14, die an ihrer Außenseite ganzflächig mit einer Kupferschicht versehen ist.

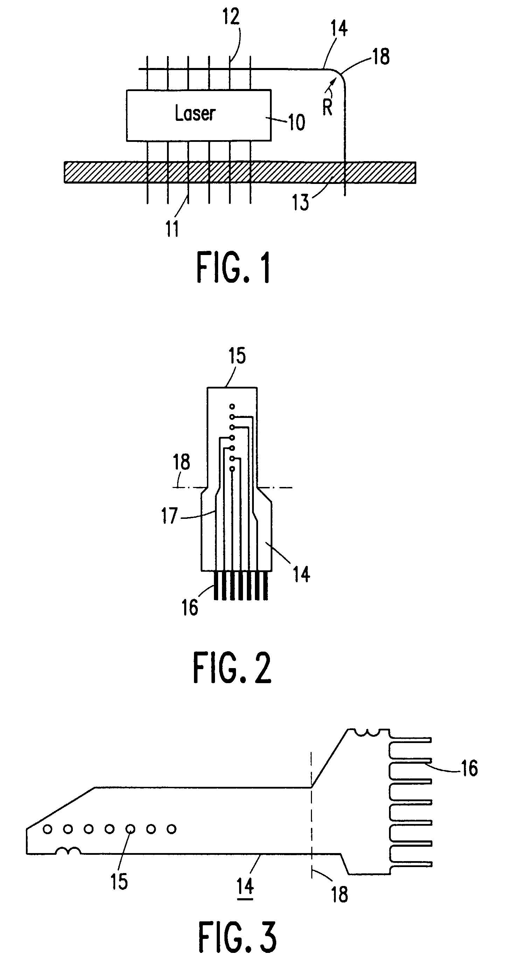

Fig. 3 zeigt eine konkrete Ausgestaltung einer flexiblen Leiterplatte 14 gemäß der Erfindung, wobei mit 18 die Biegelinie bezeichnet ist.

## Patentansprüche

1. Verfahren zur Montage eines an seiner Ober- und Unterseite mit Anschlußstiften (12, 11) versehenen Bauteiles (10), z.B. eines Lasers, auf einer Basisleiterplatte (13), wobei das Bauteil (10) über seine unteren Anschlußstifte (11) direkt mit der Basisleiterplatte (13) verbunden wird, dadurch gekennzeichnet, daß die oberen Anschlußstifte (12) mit der Basisleiterplatte (13) durch eine vorgebogene flexible Leiterplatte (14) die aus einem Verbundwerkstoff aus einem Epoxidharz und einem Glasfasergewebe besteht, verbunden werden, wobei die Leiterplatte (14) eine beidseitige Kupferbeschichtung aufweist, die außenseitig entweder vollflächig oder in Form von Kupferbahnen (17) und innenseitig in Form von Kupferbahnen ausgeführt ist.

2. Verfahren nach Anspruch 1, dadurch gekennzeichnet, daß eine Leiterplatte (14) verwendet wird, bei der die Kupferbahnen (17) quer zur Biegeachse (18) verlaufen.

3. Verfahren nach Anspruch 1 oder 2, gekennzeichnet durch Verwendung einer Leiterplatte (14) aus einen etwa 0,2 mm dicken Verbundwerkstoff, der beidseitig mit einer Kupferschicht von ca. 70 µm versehen ist.

4. Verfahren nach einem der Ansprüche 1 bis 3, dadurch gekennzeichnet, daß eine Leiterplatte eingesetzt wird, bei der die Biegezone mindestens zu etwa 75% mit Kupfer bedeckt ist.

5. Anordnung nach einem der Ansprüche 1 bis 4, gekennzeichnet durch Verwendung einer Leiterplatte (14), die einen den Glas-Harz-Verbund nicht beschädigenden Biegeradius (R) aufweist.

## Claims

1. Method for mounting a component (10) which is provided with connecting pins (12, 11) on its top and bottom, for example a laser, on a base printed circuit board (13), the component (10) being directly connected via its lower connecting pins (11) to the base printed circuit board (13), characterized in that the upper connecting pins (12) are connected to the base printed circuit board (13) by a pre-bent flexible printed circuit (14) which is made of a composite material composed of an epoxy resin and a glass-fibre fabric, the printed circuit (14) having a copper coating on both sides which is designed such that, on the outside, it either covers the entire area or is in the form of copper tracks (17) and, on the inside, is in the form of copper tracks.

2. Method according to Claim 1, characterized in that a printed circuit (14) is used in which the copper tracks (17) run transversely with respect to the bending axis (18).

3. Method according to Claim 1 or 2, characterized by the use of a printed circuit (14) made of a composite material which is about 0.2 mm thick and is provided on both sides with a copper coating of about 70 µm.

4. Method according to one of Claims 1 to 3, characterized in that a printed circuit is used in which at least about 75% of the bending zone is covered with copper.

5. Arrangement according to one of Claims 1 to 4, characterized by the use of a printed circuit (14) which has a bending radius (R) that does not damage the glass-resin composite.

## Revendications

1. Procédé de montage d'un composant (10) muni sur son côté supérieur et son côté inférieur de tiges de connexion (12, 11), par exemple d'un laser, sur une plaque conductrice support (13), le composant (10) étant relié directement par l'intermédiaire de ces tiges de connexion inférieures (11) à la plaque conductrice support (13), caractérisé en ce que les tiges de connexion supérieures (12) sont reliées à la plaque conductrice support (134) par une plaque conductrice flexible préalablement cambrée (14), qui se compose d'un matériau composite en une résine époxy et en un tissu de fibres de verre, la plaque conductrice (14) présentant un revêtement de cuivre des deux côtés, qui est réalisée côté extérieur, soit sur toute la surface soit sous la forme de pistes de cuivre (17) et côté intérieur sous la forme de pistes de cuivre.

2. Procédé selon la revendication 1, caractérisé en ce qu'une plaque conductrice (14) est utilisée, dans laquelle les pistes de cuivre (17) s'étendent transversalement à l'axe de flexion (18).

3. Procédé selon la revendication 1 ou 2, caractérisé par l'utilisation d'une plaque conductrice (14) en un matériau composite d'environ 0,2 mm d'épaisseur, qui est muni des deux côtés d'une couche de cuivre d'environ 70 µm.

4. Procédé selon l'une quelconque des revendications 1 à 3, caractérisé en ce qu'une plaque conductrice est utilisée, dans laquelle la zone de flexion est recouverte de cuivre au moins à environ 75%.

5. Dispositif selon l'une quelconque des revendications 1 à 4, caractérisé par l'utilisation d'une plaque conductrice (14), qui présente un rayon de flexion (R) ne détériorant pas le matériau composite verre-résine.
